# EUROPEAN PATENT APPLICATION

(11) **EP 3 312 869 A1**
(43) Date of publication of application: **25.04.2018**
(21) Application number: 17186577.7
(22) Date of filing: 17.08.2017
(51) Int. Cl.: H01J 37/305, C22B 9/22, H01J 37/301, H01J 37/077, C30B 13/16, C30B 15/14, C30B 13/22, C30B 15/16

(54) **THE GAS-DISCHARGE ELECTRON GUN**

(30) Priority: 21.10.2016 LV 160072
(71) Applicant: KEPP EU, SIA, 1034 Riga (LV)
(72) Inventor: Kravtsov, Anatoly, LV-1011 Riga (LV); Kravtsov, Alexey, LV-1011 Riga (LV)
(74) Representative: Zaboliene, Reda

(57) **Abstract**

The proposed invention relates to electronic technology, more specifically to gas-discharge electron guns for processing applications and can be used for electron beam melting of materials, in particular metals and substances, which melts have metallic properties (hereinafter referred to as metals), their vacuum purification and other thermal processes performed in a vacuum using high-power electron beams.

The goal of the proposed invention is to solve the task of improving the stability of electron-beam guns due to stabilisation of pressure in the gas-discharge volume and reducing the deposition of processed material's vapours onto the gun's elements. The set objective is achieved due to the fact that the gas-ballast chamber reducing the pressure fluctuations in the process chamber affecting pressure in the gas-discharge volume of the electron beam gun is installed between the focusing lenses into the beam guide connecting the anode aperture with the process chamber.

## Description

### THE FIELD OF THE INVENTION

The proposed invention relates to electronic equipment, more specifically - to gas-discharge electron guns for processing applications and may be applied to electron beam melting of materials, particularly metals and substances, melts of which have metallic properties (hereinafter referred to as metals), their vacuum purification and other thermal processes carried out in vacuum using high-power electron beams.

### THE BACKGROUND OF THE INVENTION AND PRIOR ART

A high-voltage glow discharge is used in the cold-cathode gas-discharge electron guns for generation and formation of an electron beam. Positive ions entering from the plasma localised at the anode bombard the surface of cold concave metal cathode, creating an electron beam emission. In the cathode potential fall space, electrons are accelerated and form a converging beam with a focal length determined by the radius of curvature of the concave surface of the cathode. At a constant accelerating voltage, beam power is determined by its current regulated by the working gas pressure value in the discharge space between the electrodes (hereinafter referred to as the discharge volume). The beam is projected to technological volume (chamber) through the beam guide. The beam guide is equipped with magnetic focusing lenses and beam direction control coils. Working gas supplied to the discharge volume is also discharged there.

When melting the metal to be processed in the process chamber, the pressure inside of it periodically (without control) increases to a level exceeding the pressure in the discharge volume. Consequently, the pressure in the discharge volume increases, along with increasing discharge current. The control systems usually provided for the gas-discharge electron guns with cold-cathodes reduce both working gas inflow and current reacting to the change of pressure and current. After the pressure in the process chamber is normalised, gas pressure in the discharge volume decreases again, because the working gas flow was decreased; the current decreases and the control system makes adjustments by increasing the supply of working gas. In addition, the controlling operation of the system is periodically added with the new perturbation discharged from the process chamber, namely in case of growing working gas flow rate, the pressure in the process chamber increases independently and uncontrollably, resulting in pressure increasing in the discharge volume above the permissible level and switching-off of the gas-discharge electron gun. The minimum diameter of the opening in the bottom of the anode and beam guide contributes to reduction of pressure dependence in the interelectrode discharge volume on the pressure in the chamber, but limits the power of the output beam. It's necessary to remove this contradiction in the requirements and ensure the passage of a strong electron beam at minimum possible impact of the pressure fluctuations in the process chamber to the pressure in the discharge volume.

Methods of increasing the independence of the gas pressure in the discharge volume of the pressure oscillations in the processing chamber implemented for relatively low-voltage electron beam guns with higher accelerating voltages used in welding are known (L.N. Orlikov, "Theory and practice of projecting low-energy electron beams into gas"; Tomsk State University, Tomsk, 2002, page 150). [1]. However, the direct use of these solutions in powerful electron sources was almost not applicable due to the melting of the controlling elements.

Certain technical solutions applicable for high-current guns are known, aimed to minimise the impact of pressure fluctuations in the process chamber to the gun operation stability by the way of achieving the minimum diameter of the anode aperture with maximum current of the beam.

In the known technical solution in accordance with the US patent 3270118 [2], the discharge volume is isolated from the process chamber using a membrane with unspecified hole diameter. Such design either insufficiently isolates volumes of the interelectrode discharge gap and processing chamber from each other, or the membrane does not allow projecting a sufficiently powerful electron beam, so the membrane it melts with the increasing power of the beam.

According to the patent RU 2323502 [3] and the utility model patent UA 18148 [4] the gas-discharge electron beam guns with cold cathode, developed concaved emitting surface and hollow anode with an opening in the bottom and the beam guide placed under the anode with focusing lenses, which connects the discharge volume to the process chamber are also known. In these solutions, according to the inventors, geometric dimensions and position of the cathode towards the anode aperture are optimised, thereby solving the set task. Moreover, in the technical solution [3] at least 3 rods electrically isolated from the beam guide are uniformly inserted into the beam guide perpendicular to its axis and equiangular-spaced, and these rods are included in the control system so that in case of expanding beam diameter the leakage currents will be primarily generated in the rods' circuit. In the case of leakage currents, the electric power parameters of the focusing lenses are changed and the beam diameter is reduced in the rods' electric circuit, so that the heating of the anode aperture should be minimised.

Both solutions are focusing the beam of maximum power and provide minimum heating of the elements of the bottom part of the anode and beam guide, but they do not protect against gases interpenetration between the process chamber and discharge volume.

A number of solutions involving the use of the intermediate chambers to control the gas balance are known.

In the technical solution accordingly to the patent RU 2314593 [5] an extra chamber is set with defined dimensions of openings, through which it is suggested to use additional pumping means, and thus provide stability of the pressure in the discharge volume for the electron beam gun with thermionic cathode. The use of such solution for the discharge electron guns is ineffective due to the possibility of complete removal of gas from the discharge volume, and thus, the termination process.

A technical solution in accordance with PCT application with A1 publication number WO2014193207A1 [6] is known, in which a gas-discharge electron gun, containing (in a sealed case on the high-voltage insulator) cold concave cathode, coaxial anode with an opening for the electron beam passage, a beam guide attached to anode with the two focusing lenses and beam deflection coils fixed on it, has a gas-ballast chamber between the focusing lens and deflection coils that covers the beam guide and is equipped with connecting branch for pumping and connected with the beam guide by openings, which transverse dimensions do not exceed 5 - 6 mm, and their total gas conductivity exceeds the beam guide conductivity between the gas-ballast chamber and its section.
If necessary, the gas-ballast chamber may be located between the focusing lenses.
In the proposed gun [6], the pumping of gas in the course of its work is carried out mainly through the gas-ballast chamber, through which the gas conductivity is greater compared to the beam guide at the segment between the gas-ballast chamber and its section. Operating experience for the mentioned solution showed that this solution has much less flaws, but flaws similar to those given for the solutions [2] and [4] still exist.

A technical solution according to the patent for utility model UA 90536 [7] is known, according to which an intermediate chamber is located between the discharge volume of the gas-discharge electron gun and the process chamber, and it is fed with inert gas at a pressure equal to the pressure of the working gas in the discharge chamber. This solution contributes to stable operation of a gas-discharge electron gun when lowering pressure in the working chamber. The disadvantages of this solution are: reduction of the beam power, which is partially dissipated by argon, and the absence of task solution when increasing the pressure in the process chamber, as well as inadequate protection of the system when increasing the pressure in the working chamber, for example caused by gas escape during melting of the bed. This technical solution is selected as the prototype of the proposed invention.

### SUMMARY OF THE INVENTION

The proposed invention solves the problem of increasing the stability of operation of the electron beam guns due to the stabilisation of pressure in the gas-discharge volume and reduction of the vapour deposition of the processed material on the gun's elements.

The technical result is as follows:
- stabilisation of the working gas pressure in the gas-discharge volume of the electron beam guns;
- no strengthening of regulating changes occurs for the working gas flowing into the discharge volume, that usually happens due to uncontrolled pressure fluctuations in the process chamber;
- no change in the output parameters of the system at constantly preset parameters of its operation occurs due to deposition of the processed material vapours on the surface of the cathode and anode of the electron beam gun.
The technical result is achieved due to the fact that the gas-ballast chamber reducing the pressure fluctuations in the process chamber affecting pressure in the gas-discharge volume of the electron beam gun is installed between the focusing lenses into the beam guide connecting the anode aperture with the process chamber.

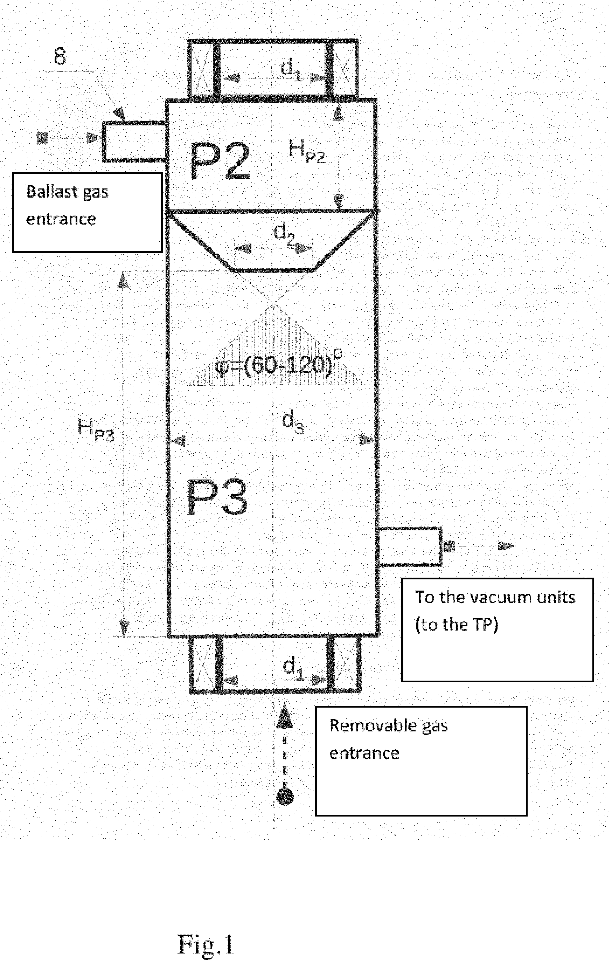

The gas-ballast chamber contains a diaphragm in the shape of a hollow truncated cone, which divides the chamber into two volumes. The volume limited with smaller base of the truncated cone is connected to a venting means, and the second volume is connected to a device for controlled supply of ballast gas to the greater base of the truncated cone (Figure 1). The technical character of the invention lies in the fact that the proposed configuration of the gas-ballast chamber contributes to reduction of the likelihood of parameter fluctuations of the gun's operation and prevents the exchange of substances' vapours among the process chamber volume P4 and gas-discharge volume P1 by improving the gas insulation between them. Enhanced insulation is achieved by adding a two-section gas-ballast chamber between the beam guide's focusing lenses separated by a diaphragm in the shape of a hollow truncated cone with its smaller base directed towards the flow of vented gases. The dimensions of the diaphragm are optimal for a minimal impact of pressure fluctuations in the process chamber to pressure changes in the gas-discharge volume at maximum current of the electron beam.

### BRIEF DESCRIPTION OF THE DRAWINGS

Fig. 1 - Typical dimensions of the gas-ballast chamber;
Fig. 2 - Diagram of the gas-discharge electron beam gun.

### DETAILED DESCRIPTION OF THE INVENTION

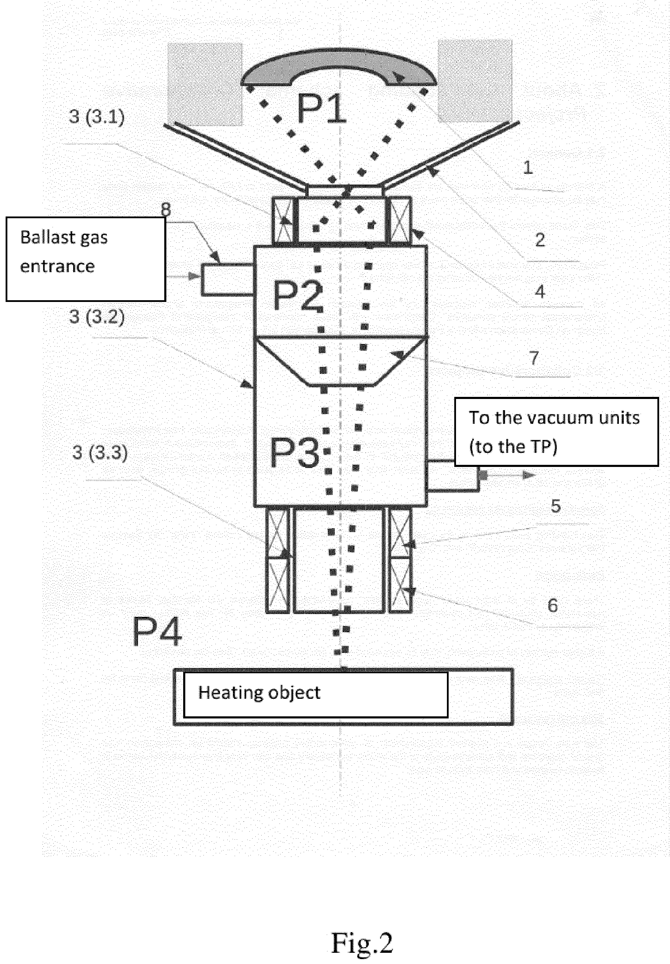

The proposed gas-discharge electron gun (Fig. 1) consists of a sealed case (not shown), in which cold metal cathode (1) is fixed, anode (2) is installed coaxially to cathode, which together form the gas-discharge volume P1, which is fed with working gas, and a beam guide (3) (3.1; 3.2 and 3.3). The beam guide features magnetic focusing lenses (4; 5) and deflection coils (6). The gas-ballast chamber (3.2) is located between the lenses (4) and (5). The gas-ballast chamber (3.2) (Fig. 2) features a diaphragm (7) in the shape of a hollow truncated cone, which separates the gas-ballast chamber into volumes P2 and P3, pumping gas pipe (9) and the opening for feeding inert gas (8). The smaller base of the truncated cone is directed towards the flow of vented gases. The ballast gas is fed to the volume P2 located at the larger base of the conical diaphragm. Work and ballast gases are removed mostly by a turbomolecular pump (TP) through the pipe (9). Feeding ballast gas into the volume P2 reduces the flow rate of working gas used to generate the same discharge current in the volume P1. Pressure in P1-P4 volumes is supported in P1>P2≥P3≈P4 ratios as shown in Fig.1. With the growth of P4>P3 pressure towards the volume P1, gas entering from the volume P4 must pass through the cylindrical diaphragm, which is a beam guide portion (3.3), and a compensating pressure growth zone P3, which output is provided with locking resistance - a conical diaphragm (7). To reduce the pressure rise dynamics in P3, the gas-ballast chamber has additional means of removing excess gas entering from P4 which is turbo-molecular pump (not shown). As a result, the pressure P2 increases significantly slower than P3, and is growing mainly due to the accumulation of working gas. Additionally, working gas pressure in the volume P1 grows more slowly than in conventional electron-beam guns, as less gas is fed than it is to be without gas-ballast chamber for the proposed technical solution. Accordingly, in view of the increase of pressure in the discharge gap, the gun's current is growing more slowly, thus fewer vibrations processed by the system stabilising output parameters of the electron beam gun. The gas-ballast chamber operates as a one-way valve: a sort of plug appears with increasing pressure P4 in the volume P3, removed by the TP from the volume P3, while the volume P4 is purified with its own pump. When pressure P4 is restored, the P2-P3 system is recovered and pressure in the volume P1 falls slower, because the working gas flow rate is significantly less compared to that of ballast gas, and two gases are vented simultaneously through the pipe (9). At the same time, the discharge current control system quite effectively increases the working gas flow rate.

### 1. An example:

The proposed gas-discharge electron gun is operated as follows. Necessary operating pressure of 10⁰-10¹ Pa is reached in the gun while the continuous pumping of gas from the gun through the gas-ballast chamber and processing chamber (P4) of the vacuum unit, as well as with puffing working gas (such as hydrogen, oxygen, etc.) into the volume P1. When applying 25 - 30 kV accelerating voltage to cathode (1), the high-voltage glow discharge is initiated, forming the electron beam. The rate of discharge current, and respectively the beam current is adjusted by changing pressure in the volume P1 (flow rate value of gas inflowing into the volume P1 at a constant speed) by several Pa units. By means of magnetic focusing lenses (4), (5) the electron beam is projected into the processing chamber P4 through the beam guide and focused on the item to be heat-treated. Deflection of the beam and scanning under the respective programme is managed by using the deflecting coils (6). The proposed device has been developed on the basis of a gas-discharge gun developed by Kyiv Polytechnic Institute, having a power of up to 100 kW at accelerating voltage of 30 kV. Under the present invention, the gun's testing was conducted at the electron beam unit for melting silicon.
Pumping of gas from the processing chamber of the unit was performed via an oil-vapour pump with a capacity of 4000 h/p.

According to the proposed solution, the beam guide (3) (Fig 2.) consisting of elements (3.1, 3.2, and 3.3) contained the gas-ballast chamber (3.2), divided into the volumes P2 and P3 by conical diaphragm (7), with its smaller base facing a potential source of gases that must be vented. To vent working and ballast gases from the volume P3 adjacent to the potential source of gases that must be vented, the TP with a capacity of 500 h/p was used. The volume P2 located at the base of the conical diaphragm was fed with ballast gas - argon. Typical dimensions of the elements are as follows: d2 ≈ ¾ d1; d3 = 2d1; H_{P3}≈d3; H_{P2}≤d1/2, where
d1 is the diameter of the beam guide;
d2 is the diameter of the opening in the smaller base of the truncated cone;
d3 is the diameter of the gas-ballast chamber;
H_{P3} is the distance from the smaller base of the diaphragm in the shape of the truncated cone to the beam guide;
H_{P2} is the distance from the larger base of the diaphragm in the form of the truncated cone to the beam guide;
The angle of inclination of the truncated cone's generatrix ϕ/2 to the axis of the electron beam gun has been tested in the range of 30-60 degrees. Upon arrival of gases to be vented into the volume P4 under the pressure of not more than 10²Pa, some increase of pressure in the volume P3 occurs, but the expansion of the gas duct from (d1) to (d3) contributes to the reduction of pressure build-up rate in the volume P3, while the pumping speed through the pipe (9) is sufficient to remove excess gas fed to the volume P3, so pressure growth does not exceed 10 Pa. Additionally, the presence of the diaphragm in the shape of the hollow truncated cone with its apex directed towards the vented gas flow helps to ensure undesirable gas flow mainly removed from the volume P3 while hardly reach the volume P2. In this case, the pressure in the volume P2 does not increase by more than 1-3 Pa. Thus, pressure in the volume P1 increases only due to gas resupplied there, feeding of which is smaller than in the electron beam gun without the proposed gas-ballast chamber, and thus is easily adjusted by the in-built gas supply means. Both the increase of the ratio of diameter (d3) to (d1) and the increase of the volume P3 help reducing the speed of pressure build-up in the volume P3 in case it is penetrated by vented gas. However, the excessive growth of the volume P3 creates the volume discharge in it. Reducing the diameter (d2) leads to lowering pressure build-up in the volume P2 with its simultaneous increase in the volume P3, but the excessive decrease of this diameter leads to limiting beam power or burn-out of the diaphragm up to the diameter corresponding to the diameter of the electron beam. Decreasing the angle of inclination of the truncated cone's generatrix ϕ/2 to the axis of the electron beam gun's hollow conical diaphragm helps reducing pressure fluctuations in the volume P2 with the same fluctuations in the volume P3, but contributes to emerging space plasma discharge in the volume P2. Given the presence of the electron dispersion, minimisation of the diameter (d2) at a given beam current is possible if the diaphragm is cooled (for example, with water) while the magnetic lenses (4) and (5) are controlled independently. In this case, the change in the parameters of the lens (4) helps reducing the cross section of the electron beam during its passing of the opening in the smaller base of the truncated cone, and the lens (5) contributes to focusing the beam at the item.

In various modes of operation of the gun proposed under this invention and the state of melting material, the pressure in the processing chamber can be maintained at a predetermined level in the range of 10² - 10⁻² Pa. The gun's performance showed good stability. The inspection of the internal surfaces of cathode and anode reflector has not revealed traces of silicon spattering.

The introduced gas-discharge electron gun is intended for electron-beam melting of materials and may be used for other thermal processes conducted in vacuum using a variety of gases, including reactive gases. Separate removing of working and ballast gas of the gun through the ballast chamber with the diaphragm provides a wider range of pressures in the material heat treatment area (from 10² Pa to 10⁻² Pa), which significantly expands the technical capabilities of the electron guns of this type.

## Claims

1. A gas-discharge electron beam gun, containing located in a sealed case on the high-voltage insulator cold concave cathode, coaxial anode with an opening for the electron beam passage, a beam guide attached to anode having beam deflection coils and focusing lenses, separated by a gas-ballast chamber that contains the connecting branch for additional pumping and means for controlled gas feeding, **characterised in that** a diaphragm in the shape of a hollow truncated cone with its smaller base directed towards the flow of vented gas is installed in the gas-ballast chamber, the gas-ballast chamber divided in said way into two parts is equipped with means for removing gas from the side of the truncated cone's smaller base and means for feeding ballast gas from the side of the truncated cone's larger base.

2. The gas-discharge electron gun according to claim 1, **characterized in that** said truncated cone is made compulsorily cooled.

3. The gas-discharge electron gun according to claim 1 and/ or 2, **characterized in that** the truncated cone has a apex angle of 60-120 degrees and opening in the smaller base having diameter less than the diameter of a beam guide.

4. The gas-discharge electron gun in accordance to claim 1 and/ or 2, **characterized in that** the diameter of the gas-ballast chamber is two times bigger than the diameter of the beam guide while the distance Hₚ₃ from epy gas-ballast chamber's section to the truncated cone's smaller base directed to that section is not less than the diameter of the gas-ballast chamber, and the distance H_{P2} between the other section of the gas-ballast chamber and the larger base of the truncated cone is less than half of the beam guide's diameter.
